Europäisches Patentamt

European Patent Office

Office européen des brevets

(19)

(11) **EP 1 082 806 B1**

(12) **EUROPÄISCHE PATENTSCHRIFT**

| | |
|---|---|
| (45) Veröffentlichungstag und Bekanntmachung des Hinweises auf die Patenterteilung: **19.03.2003 Patentblatt 2003/12** | (51) Int Cl.⁷: $H02P\ 6/06$, $H02P\ 6/00$, $G01R\ 19/00$ |
| (21) Anmeldenummer: **99932644.0** | (86) Internationale Anmeldenummer: **PCT/DE99/01368** |
| (22) Anmeldetag: **06.05.1999** | (87) Internationale Veröffentlichungsnummer: **WO 99/062169 (02.12.1999 Gazette 1999/48)** |

(54) **VERFAHREN UND SCHALTUNGSANORDNUNG ZUR STROMERFASSUNG ELEKTRONISCH KOMMUTIERTER ELEKTROMOTOREN**

METHOD AND CIRCUIT FOR POWER DETECTION IN ELECTRONICALLY SWITCHED ELECTRIC MOTORS

PROCEDE ET CIRCUIT POUR DETECTER DU COURANT DANS DES MOTEURS ELECTRIQUES A COMMUTATION ELECTRONIQUE

| | |
|---|---|
| (84) Benannte Vertragsstaaten: **AT CH DE ES FR GB IE IT LI NL SE** | (72) Erfinder: **BUSCH, Peter** D-86179 Augsburg (DE) |
| (30) Priorität: **27.05.1998 DE 19823734** | (74) Vertreter: **Hermann, Uwe, Dipl.-Ing. et al Epping, Hermann & Fischer Postfach 12 10 26 80034 München (DE)** |
| (43) Veröffentlichungstag der Anmeldung: **14.03.2001 Patentblatt 2001/11** | |
| (73) Patentinhaber: **Fujitsu Siemens Computers GmbH 81739 München (DE)** | (56) Entgegenhaltungen: DE-A- 4 040 847    DE-A- 4 321 334 US-A- 4 638 223    US-A- 5 457 366 US-A- 5 731 671 |

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren und eine Schaltungsanordnung zur Stromerfassung von elektronisch kommutierten Elektromotoren gemäß den Oberbegriffen der Ansprüche 1 bzw. 3.

Netzteile höherer Leistung brauchen zu ihrer Kühlung Lüfter, deren Elektromotor elektronisch kommutiert ist. Zur Kontrolle und zu Regelzwecken ist die Drehzahl des Elektromotors des Lüfters elektronisch zu erfassen.

Die elektronische Erfassung kann dabei schon innerhalb eines Speziallüfters erfolgen, der dann ein entsprechendes internes Taktsignal als Folge der elektronischen Kommutierung über eine zusätzliche Leitung nach außen führt. Der Nachteil dieser Speziallüfter ist, dass für sie ein höherer Preis zu bezahlen ist.

Neben den Speziallüftern ist es möglich, die Drehzahl elektronisch durch eine Drehzahlerfassungsschaltung zu erfassen, indem die vom Lüfter auf seinen Zuleitungen verursachten Stromschwankungen unter Verwendung von Strommesswiderständen ermittelt und anschließend durch einen Tiefpass ausgekoppelt werden. Das erhaltene Signal wird dann über einen Impulsformer geleitet, der ein Impulssignal mit einer entsprechend der Drehzahl des Lüfters entsprechenden Anzahl von Impulsen pro Zeiteinheit erzeugt.

Bei niedriger Betriebsspannung des Lüfters, z. B. wenn der Lüfter langsam anläuft, gerät die Kommutierungselektronik des Lüfters in Resonanz aufgrund des stromabhängigen Spannungsabfalls am Strommesswiderstand. Dies erfolgt deshalb, weil die kommutierungselektronik des Lüfters eine untere Betriebsspannungsschwelle besitzt, oberhalb derer der Betriebsstrom des Lüfters schlagartig zu fließen beginnt. Über dem Strommesswiderstand fällt dann sofort eine Spannung ab. Die Betriebsspannung des Lüfters wird wieder unter seine Betriebsspannungsschwelle gezogen. Die Kommutierungselektronik des Lüfters schaltet ab.

Dieser Vorgang wiederholt sich so lange, bis die über Lüfter und Strommesswiderstand angelegte Spannung hoch genug ist, daß die Betriebsspannungsschwelle des Lüfters beim Anlaufen nicht mehr periodisch unterschritten wird. Wird die Erfassung der Stromschwankungen des Lüfters zur Drehzahlerfassung und Drehzahlregelung des Lüfters genutzt, kann es sogar zu einem dauerhaften Verbleiben des Lüfters in diesem Zustand kommen. In diesem Fall dreht sich der Lüfter nicht, täuscht aber seiner Regelelektronik durch rasches periodisches Ein- und Ausschalten eine hohe Drehzahl vor.

Aus der DE 40 40 847 A1 ist ein Verfahren zur Überwachung der Ansteuerung eines elektronisch kommutierten Gleichstrommotors bekannt, bei dem der Laststromkreis bei Detektion eines Fehlers wiederholt ein- und ausgeschaltet wird.

Aus der US-A-5,457,366 ist eine Anordnung zur Steuerung eines Gleichstrommotors bekannt, wobei es sich bei der Steuerung um eine Mischung aus Pulsbreitenmodulation und linearer Stromsteuerung handelt. Die Schaltung ist verhältnismäßig aufwendig und zur Erfassung der Drehzahl des Motors nicht gut geeignet.

Aus der US-A-5,731,671 ist es bekannt, einen Elektromotor durch einen Spannungsfolger anzusteuern. Allerdings ist ein Strommeßwiderstand zwischen dem Elektromotor und der positiven Versorgungsspannung angeordnet, so daß die Spannung über dem Elektromotor von Spannungsschwankungen über dem Strommeßwiderstand abhängig ist.

In der DE 43 21 334 A1 ist eine Schaltung zum Betreiben eines Elektromotors vorgeschlagen, bei der ein Drehzahlsignal an einen Vergleicher weitergegeben wird, der das Drehzahlsignal mit einem in einer Tabelle hinterlegten Drehzahlbereich vergleicht. Bei einer Übereinstimmung erhöht oder senkt eine Leistungsvorgabe die für den Elektromotor vorgesehene Leistung ab. Die vorgeschlagene Schaltung eignet sich zum Reduzieren von Geräuschbelästigungen, die insbesondere innerhalb von bestimmten Drehzahlbereichen auftreten.

Aus der US-A-4,638,223 ist eine Ansteuerungsvariante für einen Gleichstrommotor mit Pulsbreitenmodulation bekannt, bei der der Mittelwert des Stromes durch den Motor durch periodisches Ein- und Ausschalten erreicht wird, wobei der Mittelwert des Stromes durch die Breite der Pulse bestimmt ist.

Aufgabe der vorliegenden Erfindung ist es daher, ein Verfahren und eine Schaltungsanordnung der eingangs genannten Art anzugeben, durch die es vermieden wird, dass es beim Anlaufen eines Elektromotors, beispielsweise eines solchen für einen Lüfter, zu einem periodischen Ein- und Ausschalten des Lüfters kommt.

Diese Aufgabe wird für das Verfahren durch den Verfahrensschritt des Anspruchs 1 gelöst. Bezüglich der Schaltungsanordnung wird diese Aufgabe durch das Merkmal des Anspruchs 3 gelöst.

Danach liegt dem Verfahren und der Schaltungsanordnung zu Grunde, dass die Elektromotorspannung vom Spannungsabfall des Strommesswiderstands durch geeignete Anordnung eines Ausgangsleistungstransistors entkoppelt ist.

Vorteilhafte Ausgestaltungen sind Gegenstand eines Unteranspruchs.

Danach ist die Startspannung so gewählt, dass sie oberhalb der oben erwähnten Betriebsspannungsschwelle der Motorelektronik liegt, um stets ein sicheres Anlaufen des Motors zu gewährleisten.

Nachfolgend wird ein Ausführungsbeispiel der Erfindung anhand einer Zeichnung näher erläutert.

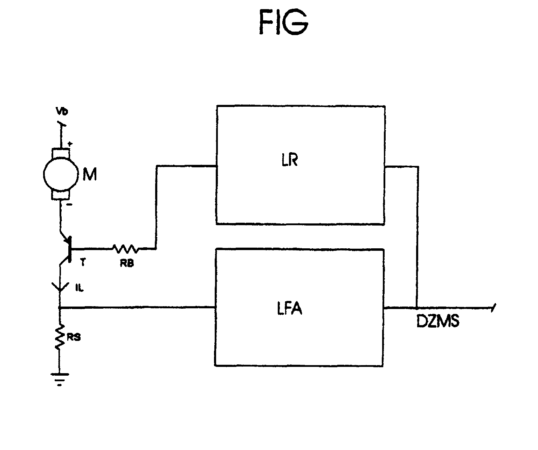

In der einzigen Figur ist ein Elektromotor M eines Lüfters gezeigt, der in einem Pfad zwischen einer positiven Versorgungsspannung Vb und einem Bezugsspannungspunkt angeordnet ist. Im vorliegenden Fall ist der Bezugspannungspunkt durch einen Massepunkt

realisiert.

Zwischen dem Elektromotor M und dem Massepunkt ist in Reihe geschaltet eine Emitter-Kollektor-Strecke eines pnp-Transistors T und ein Strommesswiderstand RS angeordnet. Zwischen dem Kollektor des Transistors T und dem Strommesswiderstand RS ist eine unter anderem eine Filter- und eine Impulsformereinheit aufweisende Lüfterdrehzahlerfassungsschaltung LFA angeschlossen. Am Ausgang der Motordrehzahlerfassungsschaltung LFA ist eine Motordrehzahlreglerschaltung LR angeschlossen, die wiederum über einen Basiswiderstand RB mit der Basis des pnp-Transistor T verbunden ist.

Die Impedanz der den Lüfter speisenden Spannung über seinen Anschlüssen entspricht annähernd dem Wert

$$RL\ddot{u}=Rb/hfe,$$

mit

hfe = Stromverstärkung von T1,
RLü = Impedanz der Spannung über den Motoranschlüssen.

Dieser Wert ist unabhängig vom Widerstandswert des Strommesswiderstands RS.

Eine weitere Verbesserung tritt ein, wenn der Leistungstransistor direkt von einer spannungsgeregelten Steuerspannung mit niedrigem Innenwiderstand Ri (mit RB=0) gespeist wird. Das ist der Fall bei einer Regelungsschaltung mit gegengekoppeltem Ausgang. Die Impedanz der Lüfterspeisespannung entspricht dann annäherend dem Wert

$$RL\ddot{u}=Ri/hfe$$

Mit Ri in der Größenordnung von unter 1 Ohm liegt der resultierende Spannungsabfall beim Einschalten der Kommutierungselektronik bei wenigen mV und führt dann nicht mehr zu einer Resonanz der Motorelektronik.

Bei der Vorgabe einer von 0V verschiedenen Startspannung, die als Startwert bei jedem Start des Motors angelegt wird, braucht die Startspannung nicht oberhalb der Betriebsspannung liegen, bei der der Motor sich zu drehen beginnt (z.B. 7V). Für eine ausreichende Spannung zum mechanischen Anlauf des Motors ist die Motordrehzahlreglerschaltung LR zuständig. Der Startwert soll nur den Spannungsbereich der Motorelektronik mit Schwingneigung überspringen. Würde man diese Startspannung unnötig hoch ansetzen, dann würde das zu einer hörbaren Drehzahlerhöhung des Motors über den Sollwert hinaus führen.

Nach dem Start der Motorelektronik wird die Motorspannung vom Startwert ausgehend aufgrund der Entscheidung der Motordrehzahlreglerschaltung LR entweder nach unten oder nach oben langsam verändert, um die Solldrehzahl einzustellen.

## Patentansprüche

1. Verfahren zum Betrieb eines elektronisch kommutierten Elektromotors, bei dem dem Elektromotor in Abhängigkeit seiner momentanen Drehzahl und einer Solldrehzahl eine über eine Spannungsregler geregelte Betriebsspannung zugeführt und zur Ermittlung seiner momentanen Drehzahl anhand von durch den Elektromotor auf seinen Versorgungsleitungen verursachten Stromschwankungen an einem Strommesswiderstand entsprechende Spannungsabfälle abgegriffen werden, **dadurch gekennzeichnet, dass** die geregelte Betriebsspannung des Elektromotors (M) dem Elektromotor (M) von den Spannungsabfällen des Strommesswiderstandes (RS) entkoppelt über den Spannungsregler zugeführt wird.

2. Verfahren nach Anspruch 1, **dadurch gekennzeichnet, dass** bei Einschaltvorgängen des Elektromotors (M) eine von 0 Volt verschiedene, oberhalb einer Betriebsspannungsschwelle und gleichzeitig unterhalb einer mechanisch bedingten Betriebsspannungsschwelle jeweils des Elektromotors (M) liegende Startspannung zugeführt wird.

3. Schaltungsanordnung zum Betrieb eines elektronisch kommutierten Elektromotors, der in einem Pfad zwischen einer Versorgungsspannung und einem Bezugspotential zusammen mit einem gesteuerten Spannungsregler und einem Strommesswiderstand in Serie angeordnet ist, wobei ein Drehzahlregler vorgesehen ist, der dem Elektromotor in Abhängigkeit seiner momentanen Drehzahl und einer Solldrehzahl eine geregelte Betriebsspannung zuführt und zur Ermittlung der momentannen Drehzahl dem Drehzahlreglerdie von dem Elektromotor an dem Strommesswiderstand verursachten Spannungsschwankungen zugeführt sind, **dadurch gekennzeichnet, dass** der Elektromotor (M) direkt an die Versorgungsspannung (Vb) angeschlossen ist und nachfolgend der gesteuerte Spannungsregler (T), und dann der Strommesswiderstand (RS) angeordnet sind, wobei der Spannungsregler die Betriebsspannung des Elektromotors von den Spannungsabfällen des Strommesswiderstandes (RS) entkoppelt zuführt.

## Claims

1. Method for operating an electronically commutated electric motor, in which the electric motor is supplied with an operating voltage, which is regulated via a voltage regulator, as a function of its instantaneous rotation speed and a nominal rotation speed, and corresponding voltage drops are tapped off across a current measurement resistor in order to determine the instantaneous rotation speed of the motor, on the basis of current fluctuations caused by the electric motor on its supply lines, **characterized in that** the regulated operating voltage of the electric motor (M) is supplied via the voltage regulator to the electric motor (M), decoupled from the voltage drops across the current measurement resistor (RS).

2. Method according to Claim 1, **characterized in that**, during procedures for switching on the electric motor (M), a starting voltage is supplied which is not 0 volts and is above an operating voltage threshold and at the same time below a mechanically dependent operating voltage threshold, in each case, of the electric motor (M).

3. Circuit arrangement for operating an electronically commutated electric motor, which is arranged in series in a path between a supply voltage and a reference earth potential together with a controlled voltage regulator and a current measurement resistor with a rotation speed regulator being provided which supplies the electric motor with a regulated operating voltage as a function of its instantaneous rotation speed and a nominal rotation speed, and with the voltage fluctuations caused across the current measurement resistor by the electric motor being supplied to the rotation speed regulator in order to determine the instantaneous rotation speed, **characterized in that** the electric motor (M) is connected directly to the supply voltage (Vb) , following which the controlled voltage regulator (T) and then the current measurement resistor (RS) are arranged, with the voltage regulator supplying the operating voltage of the electric motor, decoupled from the voltage drops across the current measurement resistor (RS).

**Revendications**

1. Procédé de fonctionnement d'un moteur électrique à commutation électronique dans lequel on envoie au moteur électrique en fonction de sa vitesse de rotation instantanée et en fonction d'une vitesse de rotation de consigne une tension de fonctionnement régulée par l'intermédiaire d'un régulateur de tension et, pour la détermination de sa vitesse de rotation instantanée, on prélève à l'aide de variations de courant provoquées par le moteur électrique sur ses lignes d'alimentation, à une résistance de mesure de courant, des chutes de tension correspondantes, **caractérisé par le fait qu'**on envoie la tension de fonctionnement régulée du moteur électrique (M) au moteur électrique (M) par l'intermédiaire du régulateur de tension et de façon découplée des chutes de tension à la résistance de mesure de courant (RS).

2. Procédé selon la revendication 1, **caractérisé par le fait que**; lors d'opérations de mise en circuit du moteur électrique (M), on envoie une tension de démarrage différente de 0 V, supérieure à un seuil de tension de fonctionnement du moteur électrique et simultanément inférieure à un seuil de tension de fonctionnement, conditionnée par la mécanique, du moteur électrique (M).

3. Circuit destiné à faire fonctionner un moteur électrique à commutation électronique qui est branché en série conjointement à un régulateur de tension commandé et à une résistance de mesure de courant dans un chemin entre une tension d'alimentation et un potentiel de référence, un régulateur de vitesse de rotation étant prévu pour envoyer au moteur électrique une tension de fonctionnement régulée en fonction de la vitesse de rotation instantanée dudit moteur électrique et en fonction d'une vitesse de rotation de consigne et, pour la détermination de la vitesse de rotation instantanée, les variations de tension provoquées par le moteur électrique sur la résistance de mesure de courant étant envoyées au régulateur de vitesse de rotation, **caractérisé par le fait que** le moteur électrique (M) est raccordé directement à la tension d'alimentation (Vb) et le régulateur de tension commandé (T) puis la résistance de mesure de courant (RS) sont agencés ensuite, le régulateur de tension envoyant la tension de fonctionnement du moteur électrique de façon découplée des chutes de tension à la résistance de mesure de courant (RS).

# FIG